Europäisches Patentamt

European Patent Office

Office européen des brevets

(19)

(11) EP 0 235 324 B1

(12) **EUROPÄISCHE PATENTSCHRIFT**

(45) Veröffentlichungstag und Bekanntmachung des Hinweises auf die Patenterteilung:
**27.12.1996 Patentblatt 1996/52**

(51) Int Cl.$^6$: **G01R 31/34**, H02K 9/24

(21) Anmeldenummer: **86102718.3**

(22) Anmeldetag: **01.03.1986**

(54) **Verfahren zur Bestimmung der Temperatur von elektrischen Betriebsmitteln**

Method for determining the temperature of electric installations in use

Procédé pour déterminer la température des installations électriques pendant leur fonctionnement

(84) Benannte Vertragsstaaten:
**CH DE FR GB LI SE**

(43) Veröffentlichungstag der Anmeldung:
**09.09.1987 Patentblatt 1987/37**

(73) Patentinhaber: **ABB Management AG**
**5401 Baden (CH)**

(72) Erfinder: **Fromm, Wilhelm, Dr.**
**CH-5417 Untersiggenthal (CH)**

(56) Entgegenhaltungen:
**DE-A- 3 114 135**        **DE-B- 1 144 835**
**US-A- 3 809 960**

- **H. Unbehauen: "Regelungstechnik I", Friedr. Vieweg & Sohn Verlag, Braunschweig 1982, Seiten 48 - 52**
- **"Microprocessor-Based Overload Protection for Motors Drives" by H. Naitoh and T. Hasegawa (Toshiba Corporation), Tokyo 1982, IEEE, Seiten 66 - 71**
- **"Thermische Abbilder zum Schutz von Niederspannungsmotoren" von H. Unterweger, Bull, ASE/UCS 67(1976), 8, 17 April, Seiten 400 - 406**

**Beschreibung**

Die Erfindung betrifft ein Verfahren zur Bestimmung der Erwärmung von elektrischen Betriebsmitteln gemäss dem Oberbegriff des Anspruchs 1.

Elektrische Betriebsmittel, wie z.B. Maschinen oder Starkstromkabel, müssen vor zu hohen Temperaturen geschützt werden. Dazu dienen Thermorelais. Diese bestimmen und überwachen die durch die innere Verlustleistung verursachte Temperaturerhöhung. Uebersteigt sie einen kritischen Wert, gibt das Thermorelais entweder eine Warnung ab oder veranlasst insbesondere bei Maschinen eine Abschaltung. Zur Verlustleistung tragen meist mehrere Verlustleistungsquellen, wie z.B. der Laststrom, die Stromgegenkomponente, die Reibung, etc., bei.

Da es technisch schwierig oder beim Betrieb der Betriebsmittel sogar häufig unmöglich ist, die Uebertemperaturen durch direkte Messung festzustellen, werden heute meist thermische Abbilder für diesen Zweck verwendet: Aus gemessenen Grössen, wie z.B. dem Laststrom, wird die Verlustleistung und daraus mittels des Abbildes die durch sie verursachte Temperaturerhöhung indirekt ermittelt.

Ueblicherweise werden die thermischen Abbilder mittels Heizband und Wärmeträger oder in Form analoger oder digitaler elektronischer Schaltungen ausgeführt. Aus H. Naitoh, T. Hasegawa (Toshiba Corporation) "Microprocessor-based overload protection for motor drives" ist ein Verfahren bekannt, bei welchem die Temperaturerhöhung auf nichtrekursive Weise über die Berechnung eines Integrals mittels eines Mikroprozesses bestimmt wird.

Das vom Mikroprozessor berechnete Integral enthält jedoch nur eine Temperaturfunktion erster Ordnung. Auch die praktisch realisierten analogen thermischen Abbilder sind in der Regel nur von erster, allenfalls von zweiter Ordnung. Ein mittels einer elektronischen Schaltung praktisch ausgeführtes thermisches Modell zweiter Ordnung ist beispielsweise aus H. Unterweger: "Thermische Abbilder zum Schutz von Niederspannungsmotoren", Bull. SEV/VSE 67 (1976)8, 17. April, S. 400 - 405, bekannt.

Zur Bestimmung der Uebertemperaturen in elektrischen Maschinen ist ein thermisches Abbild erster Ordnung (Einkörpermodell) in vielen Fällen nicht ausreichend. Einem besseren Abbild mit höherer Ordnung stehen bisher jedoch folgende Schwierigkeiten entgegen:

- Schon die technische Realisierung eines Abbildes zweiter und erst recht die von höherer Ordnung ist nur mit relativ hohem Aufwand möglich, insbesondere wenn ein weiter Einstellbereich der Parameter zugelassen werden soll. Dies gilt sowohl für elektronische Ausführungen wie auch für numerische Realisierungen mit einem Rechner. Mit zunehmender Ordnung werden immer mehr Bauelemente bzw. zusätzlicher Rechenaufwand nötig. Der Realisierung von Abbildern höherer Ordnung sind daher vom Wirtschaftlichen her enge Grenzen gesetzt. Sie ist höchstens bei Grossmaschinen vertretbar.

- Die Bestimmung der im thermischen Modell auftretenden Parameter wird mit zunehmender Ordnung des Modells immer aufwendiger bzw. praktisch nicht mehr möglich.

Aufgabe der Erfindung ist es, ein Verfahren der eingangs genannten Art anzugeben, mit dem die Erwärmung der elektrischen Maschine auf einfache und wirtschaftliche Art mit höherer Genauigkeit als mit einem Modell erster Ordnung bestimmt werden kann. Die erfindungsgemässe Lösung dieser Aufgabe ist durch die Merkmale des Anspruchs 1 gekennzeichnet.

Durch die Erfindung können auf einfache und wirtschaftliche Weise Ergebnisse wie mit thermischen Modellen praktisch beliebig hoher Ordnung erzielt werden.

Im folgenden wird die Erfindung beispielsweise erläutert. Zur Bestimmung der Erwärmung der elektrischen Maschine wird ein Integral der Form

$$\Delta \Theta (t) = \int_{t-t_0}^{t} P(t')T(t-t')dt'$$

mittels eines Mikroprozessors numerisch berechnet, wobei $\Delta \Theta (t)$ die zu bestimmende Erwärmung zum aktuellen Zeitpunkt t, P(t') den zeitlichen Verlauf der von mindestens einer Verlustleistungquelle verursachten Verlustleistung in der Maschine, T(t - t') eine Temperaturfunktion und t' die zeitliche Integrationsvariable bedeuten. Durch $t_0$ wird der Integrationsbereich festgelegt.

Der zeitliche Verlauf der Verlustleistung kann auf an sich übliche Weise bestimmt werden. Sollen z.B. als Verlustleistungsquelle die Stromwärmeverluste in der Wicklung der elektrischen Maschine berücksichtigt werden, so kann der Laststrom der Maschine bzw. dessen Effektivwert in regelmässigen Abständen diskret gemessen und daraus über

die Beziehung

$$P(t') = RI^2(t')$$

die zugehörigen Verlustleistungswerte bestimmt werden. Dies kann entweder analog oder rechnerisch mit Hilfe des Mikroprozessors erfolgen. Die ermittelten diskreten Verlustleistungswerte werden in digitaler Form fortlaufend in einem Datenspeicher für den Mikroprozessor zugreifbar abgespeichert. In ihrer Gesamtheit geben sie den zeitlichen Verlauf der Verlustleistung wieder. Natürlich könnten auch die gemessenen Laststromwerte im Datenspeicher gespeichert und die Berechnung der Verlustleistungswerte erst bei der numerischen Berechnung des Integrals ausgeführt werden.

Im Datenspeicher müssen jeweils die im Zeitbereich $(t - t_0)$ bestimmten Verlustleistungswerte bzw. Laststromwerte enthalten sein, über die die numerische Integration erstreckt werden soll Mit jedem neu hinzukommenden Verlustleistungsoder Laststromwert kann der jeweils "älteste Wert" im Datenspeicher, der je nach den charakteristischen Zeitkonstanten der speziellen Maschine bereits mehrere Stunden alt sein kann und auf Grund des neuen Wertes aus dem Integrationsbereich herausfällt und nicht mehr benötigt wird, gelöscht oder überschrieben werden. Der Datenspeicher kann beispielsweise ein Schieberegister sein.

Gemäss der Erfindung wird als Temperaturfunktion der nicht lediglich einem thermischen Abbild erster Ordnung der Maschine entsprechende Erwärmungsverlauf in der Maschine nach einem Einheitsimpuls der Verlustleistung verwendet. Einem Abbild erster Ordnung entspricht ein rein exponentieller Erwärmungsverlauf.

Der Erfindung liegt die Ueberlegung zugrunde, dass eine beliebige, durch eine Verlustleistungsquelle verursachte Temperaturänderung an einer beliebigen Stelle in der Maschine als Ueberlagerung der Temperaturverläufe berechnet werden kann, die sich als Folge von impulsförmigen Verlustleistungsänderungen ergeben. Die entsprechenden Temperaturverläufe werden auch als Impulsantwort bezeichnet.

Auf einen Einheitsimpuls der Verlustleistung hin ergibt sich für eine bestimmte elektrische Maschine immer die gleiche, für die elektrische Maschine charakteristische Impulsantwort.

Es genügt deshalb, die für die zu überwachende bzw. zu schützende elektrische Maschine bzw. eine ganze Serie solcher Maschinen charakteristische Impulsantwort einmalig zu bestimmen und sie als eine Folge diskreter, digitaler Werte in einem Datenspeicher für den Mikroprozessor zugreifbar fest abzuspeichern. Es kann dies der gleiche Datenspeicher sein, in dem auch die Verlustleistungswerte bzw die Laststromwerte abgespeichert werden.

Die Bestimmung der für die zu überwachende Maschine charakteristischen Impulsantwort kann experimentell, d. h. durch direkte Messung, oder auch rechnerisch, beispielsweise auf einem leistungsfähigen Rechner, erfolgen.

Die Impulsantwort kann dabei leicht mit einer Genauigkeit ermittelt werden, die die Genauigkeit der idealisierten Temperaturverläufe von Modellen erster oder auch zweiter Ordnung erheblich übertrifft und nur von Modellen weit höherer Ordnung, wenn überhaupt, erreicht würde.

Da die Bestimmung der Impulsantwort, wie ausgeführt, nur einmal erforderlich ist, ist ein gewisser Aufwand zu ihrer genauen Ermittlung gerechtfertigt.

Zu betonen ist, dass der Aufwand zur numerischen Berechnung des oben angegebenen Integrals weitgehend unabhängig ist vom Aufwand der Bestimmung der Impulsantwort. Für den Mikroprozessor, der die numerische Berechnung durchführt, spielt es keine Rolle, ob die diskreten Werte der Temperaturfunktion lediglich eine Exponentialfunktion oder mehr oder weniger exakt der tatsächlichen Impulsantwort entsprechen.

Die Bestimmung der Impulsantwort kann auch über den Umweg der Bestimmung der Temperaturantwort auf einen Einheitssprung der Verlustleistung, der sogenannten Sprungantwort erfolgen, denn die Impulsantwort h(t) kann aus der Sprungantwort s(t) einfach über die Ableitung nach der Zeit berechnet werden:

$$h(t) = ds(t)/dt.$$

Im Rahmen des erfindungsgemässen Verfahrens lässt sich in einfacher Weise auch der Einfluss mehrerer Verlustleistungsquellen berücksichtigen. Dies erfolgt dadurch, dass die von den verschiedenen Verlustleistungsquellen verursachten Erwärmungen zu einer Gesamterwärmung aufsummiert werden. Die einzelnen Beiträge zur Gesamterwärmung können unabhängig voneinander wie oben beschrieben bestimmt werden. Wenn für einzelne Verlustleistungsquellen die Temperaturfunktionen T(t-t') gleich sind, können die zugehörigen Verlustleistungen zu einer Gesamtverlustleistung aufsummiert werden; die Gesamterwärmung ergibt sich dann aus der numerischen Berechnung eines Integrals mit der Gesamtverlustleistung und der gemeinsamen Temperaturfunktion.

Nach Bestimmung der Erwärmung der Maschine kann deren absolute Temperatur einfach durch Addition der Umgebungstemperatur bestimmt werden.

Anstelle des vorgenannten Integrals könnte auch das Integral

$$\Delta \ominus (t) = \int_0^{t_0} P(t - t') \cdot T(t')dt'$$

berechnet werden, da dieses mathematisch gleichwertig ist.

**Patentansprüche**

1.  Verfahren zur Bestimmung der Temperatur von zu überwachenden bzw. zu schützenden elektrischen Betriebsmitteln, welches die folgenden Verfahrensschritte aufweist:

    a) Bestimmung einer Temperaturfunktion T(t-t'), wobei diese Temperaturfunktion T(t-t') als charakteristische Impulsantwort des Betriebsmittels auf einen Einheitsimpuls der Verlustleistung vorab ermittelt wurde,

    b) Speicherung dieser Temperaturfunktion T(t-t') als eine Folge diskreter digitaler für einen Mikroprozessor zugreifbaren Werte in einem ersten Datenspeicher,

    c) Ermittlung des zeitlichen Verlaufs P(t') der von mindestens einer Verlustleistungsquelle des Betriebsmittels verursachten Verlustleistung mit Hilfe einer fortlaufenden Messung mindestens einer geeigneten Grösse,

    d) Speicherung dieses zeitlichen Verlaufs P(t') als eine Folge diskreter digitaler für den Mikroprozessor zugreifbaren Werte in einem zweiten Datenspeicher,

    e) Berechnung der Temperatur des Betriebsmittels aufgrund der Beziehung

    $$\Delta \Theta (t) = \int_{t-t_0}^{t} P(t') \cdot T(t-t')dt'$$

    wobei die gespeicherten Daten mittels des Mikroprozessors verabeitet werden, dabei ist $\Delta\Theta$ (t) die Temperatur im aktuellen Zeitpunkt t und t' die zeitliche Integrationsvariable, durch $t_0$ wird der Integrationsbereich bestimmt.

2.  Verfahren nach Anspruch 1, dadurch gekennzeichnet,

    -   dass die mindestens eine geeignete Grösse, welche der Ermittlung der Verlustleistung dient, ein Laststrom oder ein Rotorstrom oder eine Stromgegenkomponente ist.

3.  Verfahren nach Anspruch 1 oder 2, dadurch gekennzeichnet,

    -   dass bei der Ermittlung der Verlustleistung mehrere Verlustleistungsquellen berücksichtigt werden.

**Claims**

1.  Method for determining the temperature of electrical equipment to be monitored or to be protected, which method has the following steps:

    a) determination of a temperature function T(t-t'), this temperature function T(t-t') having been determined in advance as a characteristic impulse response of the electrical equipment to a unit impulse of the power loss,
    b) storage of this temperature function T(t-t') as a sequence of discrete digital values, which can be accessed by a microprocessor, in a first data memory,
    c) determination, with the aid of continuous measurement of at least one suitable variable, of the temporal characteristic P(t') of the power loss caused by at least one power loss source of the equipment
d) storage of this temporal characteristic P(t') as a sequence of discrete digital values, which can be accessed by the microprocessor, in a second data memory,
e) calculation of the temperature of the equipment on the basis of the relationship

$$\Delta\theta(t) = \int_{t-t_0}^{t} P(t') \cdot T(t-t') \, dt'$$

the stored data being processed by means of the microprocessor, in which case $\Delta\theta(t)$ is the temperature at the current time t and t' is the temporal integration variable, while $t_0$ determines the integration interval.

2. Method according to Claim 1, characterized in that the at least one suitable variable which serves to determine the power loss is a load current or a rotor current or a current negative-sequence component.

3. Method according to Claim 1 or 2, characterized in that a plurality of power loss sources are considered when determining the power loss.

**Revendications**

1. Procédé destiné à déterminer la température de matériels électriques à surveiller ou à protéger, lequel comporte les étapes suivantes :

a) Définition d'une fonction de température T(t-t'), cette fonction de température T(t-t') ayant été préalablement déterminée comme étant la réaction aux impulsions caractéristique du matériel électrique à une impulsion d'unité de perte de puissance,
b) Enregistrement de cette fonction de température T(t-t') sous la forme d'une série de valeurs numériques discrètes accessibles à un microprocesseur dans une première mémoire de données,
c) Détermination de l'évolution dans le temps P(t') de la perte de puissance provoquée par au moins une source de perte de puissance du matériel à l'aide d'une mesure continue d'au moins une grandeur appropriée,
d) Enregistrement de cette évolution dans le temps P(t') sous la forme d'une série de valeurs numériques discrètes accessibles au microprocesseur dans une deuxième mémoire de données,
e) Calcul de la température du matériel sur la base de l'équation

$$\Delta\theta(t) = \int_{t-t_0}^{t} P(t') \cdot T(t-t') \, dt'$$

les données mémorisées étant traitées à l'aide du microprocesseur, $\Delta\Theta(t)$ étant ici la température à l'instant t et t' la variable d'intégration dans le temps, la plage d'intégration étant déterminée par t0.

2. Procédé selon la revendication 1, caractérisé par le fait que ladite au moins une grandeur appropriée, laquelle sert à déterminer la perte de puissance, est un courant de charge ou un courant de rotor ou une composante de contre-réaction.

3. Procédé selon la revendication 1 ou 2, caractérisé par le fait que plusieurs sources de perte de puissance sont prises en considération lors de la détermination de la perte de puissance.